# EUROPEAN PATENT SPECIFICATION

(11) **EP 1 523 002 B1**
(45) Date of publication and mention of the grant of the patent: **07.05.2008**
(21) Application number: 04022395.0
(22) Date of filing: 21.09.2004
(51) Int. Cl.: G11B 7/24, G11B 7/26, C23C 14/08, B41M 5/26

(54) **Information recording medium, method of manufacturing the same, and sputtering target**
Informationsaufzeichnungsmedium, Herstellungsverfahren und Sputtertarget hierzu
Support optique d'enregistrement d' informations, procédé et cible de pulverisation, mis en oeuvre pour sa fabrication

(30) Priority: 08.10.2003 JP 2003349419
(43) Date of publication of application: 13.04.2005
(73) Proprietor: MATSUSHITA ELECTRIC INDUSTRIAL CO., LTD, Kadoma-shi, Osaka 571-8501 (JP)
(72) Inventor: Uno, Mayumi, Izumi-city Osaka 594-0041 (JP); Kojima, Rie, Kadoma-city, Osaka 571-0030 (JP); Yamada, Noboru, Hirakata city, Osaka 573-1104 (JP)
(74) Representative: Eisenführ, Speiser & Partner

(56) References cited:
- EP-A- 1 486 965
- US-A- 3 971 874
- US-A- 4 587 209
- US-A- 4 624 914
- US-A- 4 659 588
- US-A- 4 916 048
- US-A- 5 401 609
- US-A- 5 598 399
- US-A- 5 981 014
- US-A- 6 103 330
- PATENT ABSTRACTS OF JAPAN vol. 017, no. 554 (C-1118), 6 October 1993 (1993-10-06) & JP 05 156442 A (NEC HOME ELECTRON LTD), 22 June 1993 (1993-06-22)

## Description

### BACKGROUND OF THE INVENTION

### 1. Field of the Invention

The present invention relates to an optical information recording medium able to record/reproduce information with high density and high speed, a method of manufacturing the same, and a sputtering target.

### 2. Description of the Prior Art

As a medium which is available for recording/reproducing information with high capacity and high speed, an information recording medium such as a magnetic optical recording medium and a phase-changeable recording medium have been known. When recording information, these media take advantage of the fact that a recording material changes its optical properties with heat caused by applying a laser locally onto the material. Other than these optical information recording media, an information recording medium for recording information electrically such as a memory card has also been known. Because these information recording media have notable advantages in that random access is available if required and that the medium makes it easy to take anywhere, the importance of the role of the medium has been increasing more than ever recently. For example, demand for the media is increasing in various fields, such as; recording or saving of individual data, image information and the like in a computer; use in the medical field or an academic field; and moving away from home-use video tape recorders. At present, for these information recording media, to achieve a much larger capacity, higher density and higher speed is required with the developments in performance of applications and image information.

As a variety of conventionally proposed media, there are rewritable media available for rewriting many times, and write-once media available for writing only once. The write-once medium is easy to produce because the medium generally has fewer number of layers compared to the rewritable medium, thus the medium becomes inexpensive. In addition, since the write-once medium can not be rewritten, this medium is favorable for users who want to hold data that should not be destroyed. The write-once medium having a long storage life and high reliability is expected to be in great demand for archival usage. Thus, along with the popularization of the rewritable type medium with high density, demand for the write-once medium with high density is also expected to further increase.

Conventionally, as a recording material for the write-once type, several oxide materials have been proposed. For example, a result has been disclosed that a recording material, in which Te particles are diffused into an oxide base material such as GeO₂, TeO₂, SiO₂, Sb₂O₃ or SnO₂, has high sensitivity and produces a large signal amplitude (see Japanese unexamined patent publication S58-54338). For example, a recording material containing Te-O-Pd as a main component has been known to achieve large signal amplitude and have higher reliability. (T. Ohta, K. Kotera, K. Kimura, N. Akahira and M. Takenaga, "New write-once media based on Te-TeO2 for optical disks", Proc. of SPIE, Vol.695 (1986), pp.2-9). A recording mechanism of these Te-O-M type recording materials (here, M is a material which contains at least any one of a metal element, a semi-metal element, and a semiconductor-metal element) is as follows. A Te-O-M film after film formation is a compound material containing particles of Te-M, Te or M diffused uniformly into TeO₂. After applying an optical laser, because portion of the material melts and Te, Te-M or M separates out into larger crystalline particles, the optical condition changes and the difference in the condition is detected as a signal. Further, because the material of which a main component is Te-O-M is an oxide having a lower than stoichiometric amount of oxygen, the transmission rate of the film can be a large value, and the material has the advantage that it can be applied to a multi-layered optical information medium having multiple information layers. (K. Nishiuchi, H. Kitaura, N. Yamada and N. Akahira, "Dual-Layer Optical Disk with Te-O-Pd Phase-Change Film", Jpn. J. Appl. Phys. Vol.37 (1998), pp.2163-2167).

When producing a write-once type oxide recording material, a so-called reactive film forming method is generally employed, which is performed by introducing oxygen into a film-forming gas. The method brings advantages, in that oxides having good film qualities are easily obtained and that oxides having different compositions are easily produced by changing the oxygen concentration in the film-forming gas. However, when performing the reactive film formation method on a mass production line for the medium, the problem described below occurs. On a mass production line, the distance between a target and a substrate is often arranged to be very close in order to shorten tact, thus the film formation rate will become very fast. In this case, if the formation method is performed by introducing a large amount of oxygen into the film forming gas, because variation oxygen flow easily occurs and the composition ratio of oxygen contained in the formed recording film easily varies, then each medium produced will have different properties.

US 4,659,588 discloses a method of producing an optical recording medium having a thin film photo sensitive layer provided on a board. The optical recording medium in accordance with this document contains a TeO₂ compound thin film photosensitive layer. This document teaches components of a sintered body to be used as a vacuum deposition source.

US 4,624, 914 likewise refers to a method for producing an optical information-recording medium. The medium in accordance with this document contains a photosensitive thin layer consisting of Te, O and Pd.

### SUMMARY OF THE INVENTION

An object of the present invention is to solve the problem described above, and to provide a method of manufacturing an information recording medium that can produce an oxide type recording material that is stable and which has good reproducibility on a mass production line.

This object is solved by the manufacturing method and sputtering target as defined in the attached claims.

Producing a stable thin film oxide with high reproducibility becomes possible on a mass production line.

Here, the material M preferably contains at least any one of Pd, Au, Pt, Ag, Cu, Sb, Bi, Ge, Si, Sn and In, and particularly, at least any one of Pd, Au, Pt and Ag, because an information recording medium that has a tolerance to high-speed recording can be obtained.

As the sputtering target used for producing a recording layer, a material denoted by (TeO₂)ₐTe_{b}M_{c}X_{d} is preferable. Note that, a, b, c, and d satisfy a+b+c+d=100, 0≤b, 0<c, and 0≤d, and more preferably, satisfy 50≤a≤95, 5≤b+c≤40, and 0≤d≤20. Furthermore, a is preferably 60≤a≤90. In addition, b and c preferably satisfy 0.5b≤c (0<b). Herewith, an information recording medium having higher signal quality can be obtained.

In addition, the material X preferably contains fluorides and/or oxides. Herewith, an information recording medium with higher signal quality can be obtained.

A film forming gas used in a method of producing a recording layer contains at least noble gas and O₂ gas, and when a flow rate of the noble gas is x and a flow rate of the O₂ gas is y, they preferably satisfy the relationship 0≤y≤0.2x

Furthermore, the recording layer contains at least an oxide A-O and A (the atomic ratio of O to the material A is less than a stoichiometric composition, hereinafter referred to as having a "lower oxygen content") and the sputtering target contains at least an oxide A-O and A, and the oxide A-O has an atomic ratio of O to A which is within the stoichiometric composition range. From the above, producing a stable thin oxide film with high reproducibility becomes possible on a mass production line.

Moreover, the information recording medium produced by the above-mentioned manufacturing method can provide media having a smaller difference of quality and having stable properties on a mass production line. Particularly, when producing an information recording medium including multiple information layers, at least one of the information layers preferably has a recording layer which is produced by the manufacturing method. In this situation, in particular, the differences due to production of the information layers need to be reduced. By applying the method of the present invention, information recording media with smaller film forming differences are obtained.

Additionally, when producing an information layer including multiple layers, it is preferable that the composition of the sputtering target used be different with regard to at least two of the processes for manufacturing the recording layers of the information layer. Particularly, the composition ratio of oxygen contained in the sputtering target is preferably different. Thus, for the information recording medium including an information layer having multiple layers, a good balance of recording properties of each information layer is easily achieved.

In the process of producing the recording layer, the film-forming rate is preferably 4.0 nm/s or more. For example, when forming a recording layer of 30 nm thick in two film forming chambers, because the film formation is performed at a rate of 15 nm per chamber, if the film forming rate is 4.0 nm/s or more, then the film formation in each chamber can be performed at 3.75 sec per chamber or less. Thus, even including exhaust time, mass production can be feasible at tact of 5 sec or less. As just described, when the film forming speed is extremely fast, the effect of improving the film forming stability of the present invention will be prominent. The faster the film forming rate is, the shorter the time for mass production of the media will be.

As described above, in the present invention, yield improves when producing information recording media containing a write-once recording layer made from an oxide material having a lower oxygen content, and productivity improves. Therefore, an information recording medium can be provided at low-cost and with high-capacity.

### BRIEF DESCRIPTION OF THE DRAWINGS

Fig. 1 is a diagram showing an example of a layer structure of a medium produced by the manufacturing method of an embodiment of the present invention.
Fig. 2 is a diagram showing another example of a layer structure of a medium produced by the manufacturing method of an embodiment of the present invention.
Fig. 3 is a diagram showing an example manufacturing equipment of an embodiment of the present invention.
Fig. 4 is a diagram showing another example of a layer structure of a medium produced by the manufacturing method of an embodiment of the present invention.

### DESCRIPTION OF THE PREFERRED EMBODIMENTS

An embodiment of the present invention will be described below. For an optical information recording medium produced by the method of the present invention, a recording layer of the medium includes a write-once recording material containing oxides. Particularly, a material having a lower oxygen content than a stoichiometric oxide composition is used for the recording layer.

A sputtering target of the present invention contains A-O, and A and/or M. By using the target, a recording layer which contains A-O or A-O-M can be formed. Previously, a large amount of oxygen was introduced to a sputtering target which contains A, or A and M to form a recording layer which contains A-O or A-O-M. On the contrary, if the sputtering target of the present invention is employed, a similar recording layer can be formed by introducing only a noble gas, or a noble gas and a slight amount of oxygen. In addition, in a process of high-speed film formation, variations of the medium can be reduced, such as individual variations of reflectance ratio or variations of jitter on the disk surface, for example. To form a film at high-speed and to reduce variations of the medium, the sputtering target of the present invention preferably has high density (this is determined by the packing of the powder, and if the powder is packed with no space, the state is defined as 100%). The density is preferably 80% or more, or further preferably, 90% or more.

Next, an example of a manufacturing method for a sputtering target of the present invention will be described.

As an example, a manufacturing method of a sputtering target containing A-O and A will be explained. Particles of high purity material A-O having a predetermined particle diameter and particles of material A are prepared, and these materials are weighed and mixed to a predetermined mixture ratio, then are put into hot pressing equipment. The equipment is vacuumed if necessary, and the mixed material is sintered and kept as is under conditions of a predetermined high pressure and high temperature. By performing mixing sufficiently, the composition of the sputtering target becomes uniform in all directions. In addition, by optimizing the conditions of pressure, temperature and time, the filling property improves and a sputtering target with high density can be produced. Herewith, the sputtering target containing A-O and A of the predetermined composition ratio is formed. After the sintering, the material can be adhered to, for example, a flat copper plate by using a solder such as In, if necessary. In this way, the adhered material can be set in the sputtering equipment and the sputtering can be performed.

In the same way, the sputtering target containing A-O, A and M can be produced by the method described above by preparing a high purity material A-O having a predetermined particle diameter, material A and material M. Alternatively, it is also possible to prepare the following combinations of materials such as: high purity material A-O having a predetermined particle diameter and material A-M; high purity material A-O having a predetermined particle diameter, material A and material A-M; high purity material A-O having a predetermined particle diameter, material M and material A-M; or high purity material A-O having a predetermined particle diameter, material A, material M, and material A-M. The sputtering target can be produced by the method described above with any of the above combinations.

In the same way, the sputtering target containing A-O and M can be produced by the method described above by preparing high purity material A-O having a predetermined particle diameter and material M.

As a recording material of an oxide system of the present invention, an oxide A-O having a lower oxygen content than a stoichiometric composition is used (note that, A is a material which contains at least any of Te, Sb, Ge, Sn, In, Zn, Mo and W, and an atomic ratio of the material O is less than the stoichiometric composition). Then, in the process of forming a recording layer, the sputtering target contains A and an oxide A-O, and in the oxide A-O the atomic ratio of O to A is within the stoichiometric composition range. In particular, when using Sb-O as a recording material, a material containing Sb₂O₃ and Sb is used for the sputtering target. The target is produced by sintering a material containing at least Sb₂O₃ and Sb mixed at a predetermined ratio. The recording layer produced by using this sputtering target has a lower oxygen composition ratio than Sub₂O₃. Furthermore, by changing the ratio of Sb₂O₃ and Sb in the sputtering target, the film composition of the formed recording layer can be controlled.

To produce the recording layer, the film formation is preferably performed by a sputtering method using the above-mentioned sputtering target. When using the sputtering method, since film-forming equipment for mass production in which multiple-layer films are stacked has been already provided in the market, a thin film with a good quality can be relatively easily obtained by using the equipment.

As a recording layer, a material other than Sb-O is also feasible. For example, when using Sn-O as the material of the recording layer, a material containing at least SnO₂ and Sn is used as the sputtering target in the process of producing the recording layer. Here also, the same as above, a recording layer can have high reproducibility and stable properties on a mass production line. As another example, when using In-O as a recording layer material, a material containing at least In₂O₃ and In is used as the sputtering target in the process of producing the recording layer. Or when using Zn-O as a recording layer material, a material containing at least ZnO and Zn is used as the sputtering target in the process of producing the recording layer. Furthermore, as another example, Mo-O can also be employed. Then, as a sputtering target, a material which contains MoO₃ and Mo is employed. And also, a material which contains MoO₂ and Mo is also feasible. As an oxide of Mo, since many kinds of oxides exist, which have different valences within a range of compositions of MoO₂ and MoO₃, a material containing at least these oxides and Mo can also be used. The composition is chosen from values which give favorable reliability for amplitude of the recording signals.

In addition, when using W-O as a material of the recording layer, the same as for Mo-O, a sputtering target of which a material containing WO₃-W or WO₂-W is also feasible. Also for this material, since many kinds of oxides exist, which have different valences within a range of compositions of WO₂ and WO₃, a material containing at least these oxides and W can also be used.

As an oxide system recording material, the Te-O system can also be used. Then, a material containing at least TeO₂ and Te is used as the sputtering target in the process of producing the recording layer. A Te-O-M system recording material, which is made by mixing the material M in the above-mentioned material as a base material, is particularly preferable as a recording material, since the Te-O-M system recording material allows higher speed writing. A material containing at least TeO₂ and M is used as the sputtering target when producing the Te-O-M system material.

Particularly, using the target which has the composition ratio (TeO₂)ₐTe_{b}M_{c}X_{d} is preferable. Here, each of a, b, c, and d is a number satisfying the following conditions: a+b+c+d=100, 0≤b, 0<c, and 0≤d. In particular, 50≤a≤95, 5≤b+c≤40, and 0≤d≤20 are preferable. Furthermore, b and c preferably satisfies 0.5b≤c and 0<b. Hereinafter, the reasons and roles of each material will be described.

First, TeO₂ functions as a base material soon after the film formation, and its composition ratio needs to be chosen optimally because the heat conductive ratio or the signal amplitude of the recording layers differs between layers. To be more precise, the composition ratio preferably satisfies the range 50≤a≤95. If a is less than 50 mol%, the heat conductive ratio of the formed recording layer increases, and heat diffusion occurs in the film of the recording layer when performing the signal recording. As a result, the jitter value of the signal gets worse. On the other hand, if a is more than 95 mol%, the formed recording layer has an oxide composition close to that of the stoichiometric composition, so a decrease of recording sensitivity caused by a decrease of light absorption at the recording layer, or a decrease of signal amplitude occurs. The composition ratio a of TeO₂ is preferably 60≤a≤90.

Next, the material M is added to accelerate the crystallization of Te, and if it contains any elements which can bond with Te, then the same effect can be obtained. A Te crystal has a structure of chain structures, which is a spiral series of Te atoms joined by covalent bonds, the spirals being joined by a weak van der Waals' force. To dissolve Te, the weak van der Waals' force needs to be broken and thus the melting point of Te is approximately 452 degrees C which is fairly low. However, since the spiral series are still left at this time, the crystallization speed is slow. On the other hand, if a material which can make a cross-linked structure with Te is added and enables the chain structure to almost disappear, the crystallization speed can be faster.

As a specific example of a material M; elements such as Pd, Au, Pt, Ag, Cu, Sb, Bi, Ge, Si, Sn, In, Ti, Zr, Hf, Cr, Mo, W, Co, Ni, Zn, or mixed compounds of these elements are available. These materials for example, can perform single-speed recording with a Blu-ray specification (a data transmission rate is 36 Mbps). Particularly, when employing a material containing at least one of Pd, Au, Pt, Ag, Cu, Sb, Bi, Ge, Si, Sn, and In, since the cross-linked structure mentioned above can be made more effectively, a faster crystallization speed can easily be obtained. These materials can perform double-speed recording (a data transmission rate is 72 Mbps). More particularly, when using noble metals such as Au and Pd, a faster, crystallization speed can easily be obtained, and also can perform quad-speed recording (a data transmission rate is 144 Mbps).

According to the role of the material M described above, a mixture ratio c of the material M preferably satisfies 0.5b≤c and 0<b with respect to the composition ratio b of Te. If 0.5b>c, then the effect of improving the crystallization speed mentioned-above cannot be obtained.

The materials M and Te form a disperse phase among composite phases formed soon after the film formation. Therefore, the sum of these composition ratios b+c is preferably within the range between 5 mol% and 40 mol%. If b+c is less than 5 mol%, then there are less disperse phases, and a decrease of recording sensitivity and a decrease of signal amplitude after the recording easily occur. In addition, if b+c is more than 40 mol%, then there are a lot of disperse phases, so TeO₂ forming a matrix phase relatively decreases, and so the heat conductive ratio of the recording film soon after the film formation easily becomes high. It is assumed that Te and M made of metals and semiconductors have a higher heat conductive ratio than that of TeO₂ of a dielectric material. In this situation, when recording the signal, because heat diffusion across the film surface and heat interference between marks easily occurs, a favorable jitter value of signals does not tend to be obtained.

Next, a composition relationship between the sputtering target and the recording layer is described. For instance, when forming the recording layer using (TeO₂)₈₇Te₅Pd₈ (mol%) (= Te₃₄O₆₃Pd₃ (at%)) as the sputtering target under the conditions that Ar gas at 12 sccm and oxygen gas at 1.0 sccm was provided at a constant flow, a total pressure of the gas was 0.13 Pa and a power of 800 W was supplied using a high-frequency power source, then the resulting composition of the recording layer was Te₃₅O₆₂Pd₃ (at%). Although oxygen decreased slightly, it was found that the composition of the layer could be close to that of the sputtering target.

Although the main object of adding the material X is to decrease the heat conductive ratio of the formed recording layer and to obtain a signal with high quality, the material X is not always necessary in some situations. As a material itself, at least fluoride, carbide, nitride and any oxides except Te-O is contained. Particularly, when fluorides such as La-F, Mg-F, Ca-F and oxides such as Si-O, Cr-O, Ge-O are used, these materials are known to act to decrease the heat conductive ratio of the formed recording layer and allow a favorable signal quality. Since material X is mixed to control the heat conductive ratio of the recording layer soon after the film formation, it does not contribute to the signal recording. Therefore, the composition ratio d of the material X is preferably equal to or more than 0 mol% and equal to or less than 20 mol%. This is because, if the composition ratio of the material X is more than 20 mol%, the amount of variation in the optical properties before and after the recording somewhat decreases. If the heat conductive ratio is small enough after the film formation without adding the material X, then adding X is not necessary.

In the process of producing all kinds of recording layers described above, noble gases such as Ar and Xe can be employed as the film formation gas. In addition, a mixed gas of noble gas and a small amount of oxygen gas can also be employed. When performing film formation by introducing the small amount of oxygen gas into the film formation gas, a precise control of the composition ratio of oxygen in the formed recording layer is possible. In such a situation, the noble gas and the small amount of oxygen are preferably used as the film forming gas in the process of forming the recording layer. As a measure of the introduced small amount of oxygen, when the flow rate of the noble gas in the film forming gas used in the process of forming a recording layer is described as x (sccm) and that of the O₂ gas is described as y (sccm), they preferably satisfy 0≤y≤0.2x. When producing the recording material of an oxide having lower oxygen content by such a method, keeping a stable composition of the formed recording layer, the reproducibility of the film thickness and stability may be compared to what is called a reactive sputtering method (this sputtering method uses a target without oxygen, and performing a film formation in an atmosphere where a large amount of oxygen is combined with another gas). Particularly, a distance between the substrate and the target is very small to achieve fast tact in the process on a mass productive line, and an even larger amount of oxygen needs to be combined with the film forming gas if applying the reactive sputtering method when the film formation is performed under fast film forming rate conditions. In this situation, a variation of the introduced oxygen flow easily occurs, and the film thickness or the composition ratio of the formed recording layer easily varies. Correspondingly, by using the sputtering target of the present invention, and by using a noble gas, or a noble gas mixed with a small amount of oxygen gas, the recording layer having a roughly constant composition ratio and the roughly constant film thickness at any time can be produced. From this, on a mass production line where the tact is very fast, yield during the film formation of the recording layer improves and recording media at lower cost can be obtained. The effects of the method of the present invention notably appear when producing a recording layer of an oxide system under fast film forming rate conditions, such as on a mass production line.

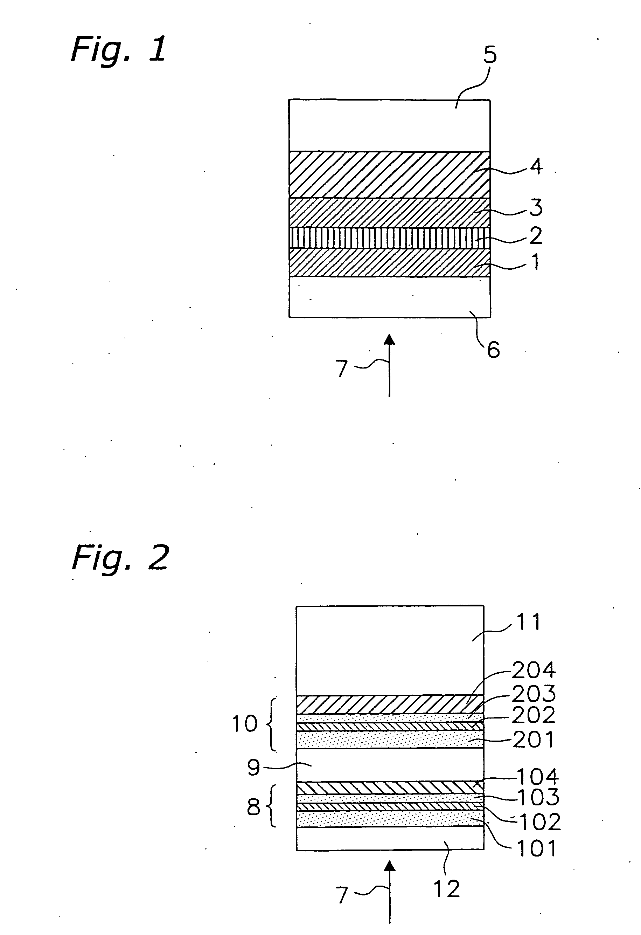

Here, at first, an example of a layer structure of the information recording medium produced by the manufacturing method of the present invention will be described. An example of the layer structure is shown in Fig. 1. In the example of Fig. 1, a protection layer 1, a recording layer 2, a protection layer 3, and a reflection layer 4 are formed on a substrate 5 in this order from the side on which an optical laser 7 is incident. On the surface of the protection layer 1, an optical transparent layer 6 is formed.

The substrate 5 and the light transparent layer 6 are protection materials to protect the information recording medium from scratches or oxidization. They are made from materials of for example, resins such as polycarbonate, polymethyl methacrylate or polyolefin system resin, or glasses or the like. Since the light transparent layer 6 performs recording/reproducing by enabling transmission of the optical laser, its material needs to be transparent against the optical laser, or if optical absorption occurs, the absorption needs to be small enough to be ignored (for example, 10% or less). A guide groove or pits for introducing the optical laser beam are preferably formed in at least one of the light transparent layer 6 or the substrate 5 on a side of the information layer.

A protection layer 1 and a protection layer 3 are applied for the main purposes of protecting the recording materials and making it possible to control optical properties such as effective light absorption at the information layer. As materials, compounds which can achieve these objects are employed, for example, sulfides such as ZnS; oxides such as Si-O, Al-O, Ti-O, Ta-O, Zr-O or Cr-O; nitrides such as Ge-N, Cr-N, Si-N, Al-N, Nb-N, Mo-N, Ti-N or Zr-N; carbides such as Ge-C, Cr-C, Si-C, Al-C, Ti-C, Zr-C or Ta-C; fluorides such as Si-F, Al-F, Mg-F, Ca-F or La-F; other dielectric materials, or proper combinations of these materials (ZnS-SiO₂ for instance).

A reflection layer 4 is made from metals such as Au, Ag, Cu, Al, Ni, Cr or Ti, or an arbitrarily selected metal compound. The layer 4 is for heat release and for getting an optical effect such as an effective light absorption at the recording layer.

As previously mentioned, the recording layer 2 includes a write-once recording material of which the main component is the oxide having a lower oxygen content. By the above-mentioned manufacturing method, differences between the media can be reduced and yield for producing the layer can be improved. The thickness of the recording layer 2 is preferably 3 nm or more and 50 nm or less. If the thickness is less than 3 nm, the recording material is less likely to have a layer structure and a favorable signal is hard to obtain. In addition, if the thickness is more than 50 nm, heat diffusion over the recording layer tends to be large, and it is difficult to obtain a favorable signal quality.

Next, another example of the layer structure of the information recording medium produced by the present invention is shown in Fig. 2. In Fig. 2, a first information layer 8, an intermediate layer 9 and a second information layer 10 are formed on a substrate 11 in this order from the side on which an optical laser 7 is incident. In this information recording medium, in order to make the recording/reproducing possible for both the first information layer 8 and the second information layer 10 by applying the optical laser 7 from one direction, the first information layer 8 needs to have a light transmission property. At the second information layer 10, since the recording is performed using a light which transmits through the first information layer 8, the recording sensitivity preferably needs to be high. Note that, the first information layer 8 includes a protection layer 101, a recording layer 102, a protection layer 103 and a reflection layer 104 in this order from the side on which the optical laser 7 is incident. On a surface of the protection layer 101, a light transparent layer 12 is formed. The second information layer 10 includes a protection layer 201, a recording layer 202, a protection layer 203 and a reflection layer 204 in this order from the side on which the optical laser 7 is incident.

An intermediate layer 9 is provided to optically separate the first information layer 8 and the second information layer 10, and it is made from a material such as a ultra-violet setting resin which passes the optical laser. The thickness of the layer 9 is chosen to allow enough separation of each information layer, and also the thickness needs to be within a range such that an objective lens can focus on the two information layers.

Also in the example of Fig. 2, the film thickness of each of the recording layers is preferably within the range between 3 nm and 50 nm. The reason is that, in addition to the same reason explained for Fig. 1, if the thickness of the recording layer is thicker than 50 nm when forming the first information layer, it is rather difficult to obtain a transmission rate high enough for this example.

In addition, in Fig. 2, although the structure of the first information layer 8 including the reflection layer is shown, the method of the present invention can be applied to such a structure of the layer 8 without the reflection layer, a structure of a protection layer 103 having two layers or media having various other structures.

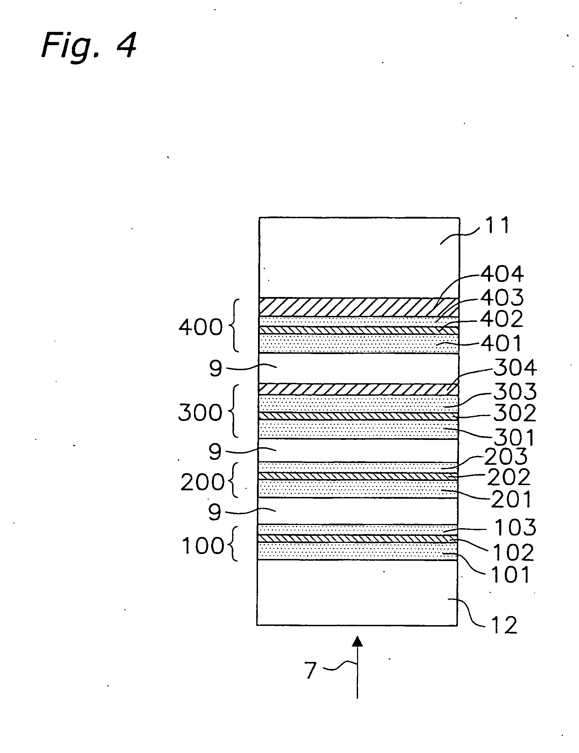

Hereinbefore, the information recording medium having two information layers has been explained, but the invention is not restricted to the above-mentioned example, and a medium on which m (m is an integer of two or more) layers are stacked is also available. Hereinafter, an example of an information recording medium having four information layers will be explained by referring to Fig. 4.

In Fig. 4, a cross-sectional diagram of the information recording medium is shown, wherein 4 information layers are stacked. On this information recording medium, a first information layer 100, a second information layer 200, a third information layer 300 and a fourth information layer 400 are formed between the substrate 11 and the light transparent layer 12 in this order from the side on which the optical laser 7 is incident. Between each information layer, an intermediate layer 9 is provided.

In an example of the structure shown in Fig. 4, a first information layer 100 includes a protection layer 101, a recording layer 102 and a protection layer 103 in this order from an incident side of the optical laser; a second information layer 200 includes a protection layer 201, a recording layer 202 and a protection layer 203 in this order; a third information layer 300 includes a protection layer 301, a recording layer 302, a protection layer 303, and a reflection layer 304 in this order; and a fourth information layer 400 includes a protection layer 401, a recording layer 402, a protection layer 403 and a reflection layer 404 in this order.

At least one of the recording layers 102, 202, 302, 402 may contain A-O or A-O-M. The layers are formed by using a sputtering target containing at least A-O, and A and/or M. With four information layers, since the first information layer 100, the second information layer 200 and the third information layer 300 require a greater transmission rate, the recording layer 102, 202 and 302 preferably have a film thickness of 15 nm or less. In such a medium, when shortening the tact by performing high-speed film formation, if the non-reactive film forming method of the present invention is employed, a thin recording layer can be formed uniformly and the difference in properties between the media or the difference of each property in a plane can be remarkably reduced.

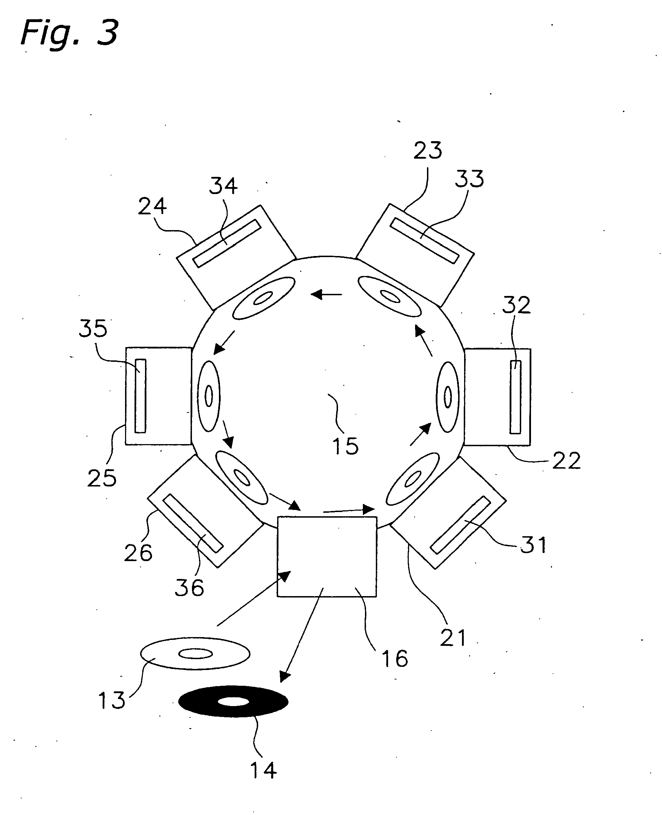

Next, a manufacturing method for an information recording medium of the present invention is explained by using diagrams. In Fig. 3, an example of the manufacturing equipment of the present invention for an information recording medium is shown. In Fig. 3, a schematic plan view of the manufacturing equipment is shown. In Fig. 3, film formation chambers 21 to 26 and a main chamber 15 are connected with a vacuum pump through an exhaust port, and can keep a high vacuum state. In addition, a gas supply port is connected to the film formation chamber 21 to 26. This makes it possible to supply a constant flow of noble gases, nitrogen gas, oxygen gas or mixed gas of these gases, and during film formation, a proper film formation gas for each chamber is supplied. In the figure, a substrate 13 (before the film formation) is put in the load lock chamber 16, and then the substrate is controlled to enter each film formation chamber 21 to 26 in this order. Finally, the disk 14 having all layers is discharged from the load lock chamber 16. In Fig. 3, codes 31 to 36 show sputtering targets provided in the film forming chambers 21 to 26, and they are connected to negative electrodes. The negative electrodes are connected to a direct-current power source through a switch and to a high-frequency power source. In addition, by earthing the film forming chambers 21 to 26 and the main chamber 15, these chambers 21 to 26, the main chamber 15, and the substrate 13 are positive electrodes. In Fig. 3, the example of the manufacturing equipment having six film forming chambers is shown, but the number of chambers is not restricted as long as the desired information recording media can be produced. For example, equipment having four, eight or thirteen chambers is also available. Generally, although the higher the number of film forming chambers is, the more expensive the manufacturing equipment will be, producing an information recording medium having multiple layers is possible. In addition, even in an information recording medium which requires a thick layer to be formed, since this thick layer can be formed by using two or more film forming chambers, the media can be produced in short tact. Therefore, the proper number of film forming chambers of the manufacturing equipment is selected in accordance with the number of layers or the thickness of each layer of the desired information recording medium.

For example, when producing a medium having a layer structure shown in Fig. 1, the reflection layer 4, the protection layer 3, the recording layer 2, and the protection layer 1 can be formed in the chamber 22, the chamber 23, the chamber 24, and the chamber 25, respectively. Here, the sputtering target 34 in the chamber 24 is the target for the film formation of the recording described previously. Alternatively, as another example of producing the medium shown in Fig. 1, the reflection layer 4, the protection layer 3, the recording layer 2, and the protection layer 1 can be formed in the chambers 21 and 22, the chamber 23, the chambers 24 and 25, and the chamber 26, respectively. In this example, even if the thickness of the reflection layer 4 and the recording layer 2 are rather thick, or even if the film forming rate is slow, film formation can finish in a time which is approximately equal to the time for forming the protection layers 1 and 3. Of course, if the protection layers 1 and 3 have approximately the same thickness, or if film forming rate is slow, two of the film chambers can be used.

### (Example 1)

Hereafter, example 1 of the present invention will be described in detail. Here, by using the manufacturing equipment shown in Fig. 3, a thin-filmed test piece was produced to analyze the oxygen composition ratio. As the structure of the test piece, ten recording layers of Te-O-Pd having 30 nm thick were stacked on a Si substrate. The manufacturing method of the test piece is explained below. First, in the manufacturing equipment shown in Fig. 3, sputtering targets 34 and 35 that are 20 cm in diameter and composed of (TeO₂)₈₇Te₅Pd₈ (mol%) were placed in film formation chambers 24 and 25. The substrate used for the test piece was Si of size 12 mm x 18 mm and 1 mm thick. This Si substrate was fixed to a film formation jig, and was placed in a load lock chamber 16. The film formation started at the film formation chamber 24, after passing through the film formation chambers 21, 22, 23. When forming a recording layer, Ar gas at 12 sccm and oxygen gas at 1.0 sccm was provided at a constant flow, and the total pressure of the gas was set to be 0.13 Pa, then a power of 800 W was supplied using a high-frequency power source. The film formation rate at this time was 5.5 nm/sec. After performing the film formation up to 15 nm in the chamber 24, the layer was moved to the chamber 25, and a formation step was performed up to 15 nm more, under the same conditions as the chamber 24. With this procedure, the recording layer of Te-O-Pd of 30 nm thickness was formed on the Si substrate using two chambers. After the film formation, the Si substrate was placed into the load lock chamber 16 by passing through the film-forming chamber 26. This material is defined as a non-reactive recording layer (1)-1. Without removing the test piece from the load lock chamber 16, the same as mentioned-above, the piece passed through the film forming chambers 21, 22 and 23, and then the recording layer of Te-O-Pd was stacked up to 30 nm on the non-reactive recording layer (1)-1 again in the film forming chambers 24 and 25. This material is defined as a non-reactive recording layer (1)-2. In this way, the experiment of stacking Te-O-Pd up to 30 nm in the film forming chamber 24 and 25 was repeated ten times, then the test piece stacked non-reactive recording layers (1)-1 to (1)-10 was removed from the load lock chamber 16.

As a comparative example, a reactive film formation was performed by using Te₈₅Pd₁₅ (at%) as the sputtering targets 34 and 35 in the film forming chambers 24 and 25, and using Ar gas at 12 sccm and oxygen gas at 36 sccm as the film forming gases. The same as above, the ten recording layers of Te-O-Pd having 30 nm thickness were stacked on the Si substrate, and reactive recording layers (0)-1 to (0)-10 are formed.

As for the non-reactive recording layers (1)-1 to (1)-10 and reactive recording layers (0)-1 to (0)-10, intensities of secondary ions of each of Te, O and Pd were evaluated by the secondary ion mass spectrometry (SIMS) method, and then converted into concentrations. Results of oxygen composition ratios for the concentrations are shown in Table 1. The first formed (1)-1 and (0)-1 layers were set to have a composition ratio of 100.0.

**[Table 1]**

| Non-reactive recording layer | Composition ratio of oxygen |
|---|---|
| (1)-1 | 100.0 |
| (1)-2 | 100.1 |
| (1)-3 | 100.0 |
| (1)-4 | 99.9 |
| (1)-5 | 99.9 |
| (1)-6 | 100.0 |
| (1)-7 | 100.0 |
| (1)-8 | 100.0 |
| (1)-9 | 100.1 |
| (1)-10 | 100.1 |

| Reactive recording layer | Composition ratio of oxygen |
|---|---|
| (0)-1 | 100.0 |
| (0)-2 | 101.5 |
| (0)-3 | 100.3 |
| (0)-4 | 99.0 |
| (0)-5 | 103.2 |
| (0)-6 | 100.8 |
| (0)-7 | 99.7 |
| (0)-8 | 98.4 |
| (0)-9 | 102.6 |
| (0)-10 | 103.5 |

As shown in Table 1, in the non-reactive recording layers (1)-1 to (1)-10, variations of oxygen composition ratio were within the range of ±0.1%. On the other hand, in the reactive recording layers (0)-1 to (0)-10, the variations were in the range of - 1.6% to +3.5%

When performing the film formation of a reactive recording layer, a mass-flow meter having the maximum flow performance of 50 sccm was used to supply oxygen gas of 36 sccm. Since the accuracy of controlling the flow of the mass-flow meter is ±2% at maximum, in this example, flow fluctuation of ± 1 sccm at absolute values is apparent. Therefore, it is assumed that because the degree of reaction between oxygen and Te results in differences in accordance with the variations of the gas flow supplied, then the oxygen composition ratio in the formed recording layer also varies.

On the other hand, when forming a non-reactive recording layer, a mass-flow meter having the maximum flow performance of 3 sccm was used to supply oxygen gas at 1 sccm. Here also, because the accuracy of controlling the flow of the mass-flow meter is ±2%, then flow fluctuation of ±0.06 sccm at absolute values is apparent. In other words, even if taking the maximum variation of flow, the flow of oxygen gas can be within the range of 0.94 sccm to 1.06 sccm. In addition, since oxygen is contained in the sputtering target and not contained in the reactive film, the phenomenon of unnecessary oxygen intake into the recording layer is minimal.

Herewith, when producing the recording layer of Te-O-Pd by the non-reactive film forming using the sputtering target of (TeO₂)₈₇Te₅Pd₈ (mol%) which contains TeO₂, Te and Pd, the variation of the composition ratio was found to improve greatly and to be available for stable mass production compared to the conventional reactive film forming method, particularly in high film forming rate conditions.

### (Example 2)

### (1) Example of the present invention

Hereinafter, example 2 of the present invention will be described in detail. Here, by using the manufacturing equipment shown in Fig. 3, an information recording medium including the layer structure shown in Fig. 1 is described. As an example, a plate of 1.1 mm thickness as the substrate 5, a disk-shaped polycarbonate resin of 120 mm diameter, a compound introducing 20 mol% SiO₂ into ZnS as the protection layer 1 and 3, a material of which the main component is Te-O-Pd as the recording layer 2, and a metal compound of Al₉₈Cr₂ as the reflection layer 4 were used. As the light transparent layer 6, a disk-shaped polycarbonate resin of 0.1 mm thickness was adhered thereto with UV resin. The protection layers 1 and 3 had a film thickness of 10 nm and 17 nm respectively, the recording layer 2 was 30 nm, the reflection layer 4 was 40 nm.

In the equipment shown in Fig. 3, the reflection layer 4 is formed in the film-forming chamber 21, the protection layer 1 and 3 are formed in the chamber 23 and 26 respectively, and the recording layer 2 is formed in the chamber 24 and 25. During film formation, sputtering target 32 is Al₉₈Cr₂, both sputtering targets 33 and 36 are a composite containing 20 mol% SiO₂ in ZnS, and both sputtering targets 34 and 35 are (TeO₂)₈₇Te₅Pd₈ (mol%). A target with a diameter of 20 cm is employed. When forming the protection layer 1 and 3, the film formation was performed by supplying a power of 2.0 kW. In this situation, the total pressure of gas, in which 2.0% oxygen was mixed in Ar, was kept at 0.13 Pa by supplying the gas with a constant flow of 12 sccm, and a high-frequency power source was used for a negative electrode. When forming the reflection layer 4, a power of 5 kW was supplied using a direct-current power source and the total pressure of gas was kept at 0.2 Pa by supplying Ar gas at a constant flow of 20 sccm. When forming the recording layer 2, a power of 800 W was supplied using a high-frequency power source and total pressure of gas was kept at 0.13 Pa by supplying Ar gas and oxygen gas at a constant flow of 12 sccm and 1.0 sccm, respectively. Noble gases such as Kr which can be used for the sputtering are also feasible as the noble gas in the sputtering gas rather than Ar. Then, a film-forming rate of the recording layer 2 was 5.5 nm/s. Since the recording layer 2 is formed up to 30 nm in the film-forming chamber 24 and the film forming chamber 25, the film formation can be performed for approximately 2.7 sec in each chamber. This medium formed by the invention is defined as a medium (1).

### (2) A comparative example

In a comparative example, regarding the film forming chamber 24 and the film forming chamber 25a used in the process of forming the recording layer 2, a medium was produced under the same conditions described above except for the conditions such as using Te₈₅Pd₁₅ as both targets 34 and 35 and using Ar at 12 sccm and oxygen at 36 sccm as a film forming gas during the reactive film formation. This medium is defined as a medium (0).

In the present example, variations of the reflectance ratio when the medium (1) and the medium (0) were continuously mass-produced in trial experiments were evaluated. In the mass trial production, 500 media were produced under the same conditions (media numbers were 1-1 to 1-500, 0-1 to 0-500), then one medium was extracted every 50 media, and the reflectance ratios of the eleven media were measured. Furthermore, in order to compare the variation in film-forming rate, media were also mass produced under the following conditions, such as the power for forming the recording layer 2 was 300W (the film forming rate was 2 nm/s), 600W (4 nm/s) and 1kW (7 nm/s). Media numbers that were mass produced using the sputtering target of (TeO₂)₈₇Te₅Pd₈ (mol %) were coded as 11-1 to 11-500, 21-1 to 21-500 and 31-1 to 31-500 for media using 300W power, 600W power and 1kW power, respectively. In addition, as a comparison; media numbers that were mass produced using the sputtering target of Te₈₅Pd₁₅(at%) were coded as 10-1 to 10-500, 20-1 to 20-500 and 30-1 to 30-500 for media using 300W power, 600W power and 1kW power, respectively. In the reactive film-forming situation of the comparative example, since a reaction easily progressed if power was not strong, oxygen flows during the film formation were optimized for each film forming power, such as 13.5 sccm, 27 sccm and 45 sccm.

Here, evaluation conditions of the reflectance ratio are explained.

For recording/reproducing evaluation, ordinary equipment for the evaluations is employed. The equipment includes; an optical header that carries the source of an optical laser and an objective lens; drive equipment for introducing the optical laser to a given position; tracking control equipment and focusing control equipment for controlling the position in the track direction and in a direction perpendicular to the film surface respectively; laser drive equipment for modulating the laser power; and rotation control equipment for rotating the information recording medium.

The evaluation of the reflectance ratio was performed by using an optical system having a laser wavelength of 405 nm and an objective lens with numerical aperture of 0.85, and by rotating the medium at a single-speed (4.92m/s). The ratio was measured by detecting the amount of light which was reflected from a groove by applying a reproduction power of 0.35 mW onto the groove at a radial position of 40 mm on the medium. Note that, the groove here is defined as a track at the closest side to the optical laser of all the tracks formed on the substrate 5. Measurement results of the reflection ratio are shown in Table 2. A design target value of the reflectance ratio was 18.5%. Note that, a variation of the ratio is defined as the following: (the maximum value - the minimum value)/the minimum value. The variation is preferably 6% or less, and is further preferably 3% or less.

**[Table 2]**

| | Film forming rate of recording layer 2 (nm/s) | | | | | | | |
|---|---|---|---|---|---|---|---|---|
| | 2 | | 4 | | 5.5 | | 7 | |
| Example | Medium number | Reflectance ratio (%) | Medium number | Reflectance ratio (%) | Medium number | Reflectance ratio (%) | Medium number | Reflectance ratio (%) |
| | 11-1 | 18.6 | 21-1 | 18.4 | 1-1 | 18.4 | 31-1 | 18.2 |
| | 11-50 | 18.6 | 21-50 | 18.4 | 1-50 | 18.4 | 31-50 | 18.3 |
| | 11-100 | 18.6 | 21-100 | 18.6 | 1-100 | 18.7 | 31-100 | 18.3 |
| | 11-150 | 18.4 | 21-150 | 18.5 | 1-150 | 18.5 | 31-150 | 18.4 |
| | 11-200 | 18.5 | 21-200 | 18.4 | 1-200 | 18.7 | 31-200 | 18.5 |
| | 11-250 | 18.6 | 21-250 | 18.5 | 1-250 | 18.3 | 31-250 | 18.7 |
| | 11-300 | 18.4 | 21-300 | 18.6 | 1-300 | 18.4 | 31-300 | 18.7 |
| | 11-350 | 18.4 | 21-350 | 18.4 | 1-350 | 18.4 | 31-350 | 18.7 |
| | 11-400 | 18.5 | 21-400 | 18.7 | 1-400 | 18.5 | 31-400 | 18.4 |
| | 11-450 | 18.5 | 21-450 | 18.5 | 1-450 | 18.7 . | 31-450 | 18.2 |
| | 11-500 | 18:5 | 21-500 | 18.6 | 1-500 | 18.6 | 31-500 | 18.6 |
| | Max. | 18.6 | Max. | 18.7 | Max. | 18.7 | Max. | 18.7 |
| | Min. | 18.4 | Min. | 18.4 | Min. | 18.3 | Min. | 18.2 |
| | Variation (%) | 1.09 | Variation (%) | 1.63 | Variation (%) | 2.19 | Variation (%) | 2.75 |

| | Medium number | Reflectance ratio (%) | Medium number | Reflectance ratio (%) | Medium number | Reflectance ratio (%) | Medium number | Reflectance ratio (%) |
|---|---|---|---|---|---|---|---|---|
| Compara -tive example | 10-1 | 18.1 | 20-1 | 19.3 | 0-1 | 18.4 | 30-1 | 17.0 |
| | 10-50 | 18.4 | 20-50 | 19.2 | 0-50 | 17.6 | 30-50 | 18.5 |
| | 10-100 | 18.5 | 20-200 | 18.5 | 0-100 | 19.0 | 30-100 | 19.4 |
| | 10-150 | 18.5 | 20-150 | 18.5 | 0-150 | 18.9 | 30-150 | 17.6 |
| | 10-200 | 18.6 | 20-200 | 18.3 | 0-200 | 19.5 | 30-200 | 18.4 |
| | 10-250 | 18.5 | 20-250 | 18.0 | 0-250 | 17.8 | 30-250 | 18.7 |
| | 10-300 | 18.5 | 20-300 | 18.6 | 0-300 | 18.5 | 30-300 | 19.8 |
| | 10-350 | 18.3 | 20-350 | 19.4 | 0-350 | 19.1 | 30-350 | 17.3 |
| | 10-400 | 18.6 | 20-400 | 19.0 | 0-400 | 18.8 | 30-400 | 19.7 |
| | 10-450 | 18.7 | 20-450 | 18.9 | 0-450 | 18.3 | 30-450 | 18.2 |
| | 10-500 | 18.2 | 20-500 | 19.5 | 0-500 | 18.0 | 30-500 | 19.1 |
| | Max. | 18.7 | Max. | 19.5 | Max. | 19.5 | Max. | 19.8 |
| | Min. | 18.1 | Min. | 18.0 | Min. | 17.6 | Min. | 17.0 |
| | Variation (%) | 3.31 | Variation (%) | 8.33 | Variation (%) | 10.80 | Variation (%) | 16.47 |

As shown in Table 2, in this example, the variation of the reflectance ratio was 3% or less when the film forming rate of the recording layer 2 was from 2 to 7 nm/s. From these results, even in a high-speed situation, the film forming was stably performed and mass production was available. On the other hand, in the results of the comparative example, the variation was over 3% even at the low rate of 2 nm/s. When the rate was over 4 nm/s, the variation was well over 6%, and the variation of the reflectance ratio was found to get larger as the film-forming rate gets higher.

Herewith, when producing the recording layer of Te-O-Pd by the non-reactive film forming using the sputtering target of (TeO₂)₈₇Te₅Pd₈ (mo I %) which contains TeO₂, Te and Pd, the variation of the reflectance ratio was found to be greatly reduced and to be available for stable mass production compared to the conventional reactive film forming method, particularly in high film forming rate conditions.

### (Example 3)

Hereafter, example 3 of the present invention is described in detail. In example 3, by using one of the mass-produced media in example 2, a reflectance ratio, C/N value and a jitter value were evaluated at an inner, an intermediate and an outer radial position on the disk surface, and their distribution over the entire disk was investigated.

Here, evaluation conditions for the C/N value and the jitter value are described. The same recording/reproducing equipment described in example 2 was employed. The optical systems included a laser wavelength of 405 nm, numerical aperture of the objective lens of 0.85 and a linear velocity of the medium of 9.84 m/s (a double-speed). As the modulation method of the signal, 1-7 PP modulation was used. Density corresponded to a capacity of 25 GB. To evaluate C/N, a single signal of 2T (its mark length was 0.149 µm) was recorded on a groove using the optimum laser power for each medium. A spectrum analyzer was employed for the measurement. In addition, to evaluate the jitter value, a random signal within the range of 2T to 8T was recorded on a groove, and a time interval analyzer was employed for the measurement. The jitter was LEQ (Limit Equalizer) jitter, and both a front-end jitter and a back-end jitter were measured and averaged. The LEQ jitter value is preferably 6.5% or less which is a standardized value. The evaluations were performed at an inner, an intermediate and an outer radial position of 23 mm, 40 mm and 58 mm, respectively.

For the examination, media having the reflectance ratio of 18.5% at the intermediate radial position were selected. Media numbers used in the example were 11-200, 21-150, 1-150 and 31-200, and those used in the comparative example were 10-250, 20-150, 0-300 and 30-50. Results of the values' distribution over the entire disk are shown in Table 3. A definition of the variation is the same as that of example 2.

**[Table 3]**

| | | | Example | | | | Comparative example | | | |
|---|---|---|---|---|---|---|---|---|---|---|
| Film forming rate (nm/s) | | | 2 | 4 | 5.5 | 7 | 2 | 4 | 5.5 | 7 |
| Medium number | | | 11-200 | 21-150 | 1-150 | 31-200 | 10-250 | 20-150 | 0-300 | 30-50 |
| Reflectance rate (%) | Radial position | Inner | 18.5 | 18.4 | 18.4 | 18.3 | 17.8 | 17.8 | 17.7 | 17.7 |
| | | Intermediate | 18.5 | 18.5 | 18.5 | 18.5 | 18.5 | 18.5 | 18.5 | 18.5 |
| | | Outer | 18.2 | 18.2 | 18.1 | 18.0 | 17.0 | 16.4 | 15.7 | 15.1 |
| | Variation (%) | | 1.65 | 1.65 | 2.21 | 2.78 | 8.82 | 12.80 | 17.83 | 22.52 |
| C/N (dB) | Radial position | Inner | 46.9 | 46.8 | 46.7 | 46.7 | 46.6 | 46.2 | 45.8 | 45.5 |
| | | Intermediate | 47.0 | 47.2 | 47.1 | 47.0 | 47.0 | 46.9 | 47.2 | 47.1 |
| | | Outer | 47.1 | 46.9 | 46.7 | 46.5 | 43.7 | 42.8 | 42.0 | 40.5 |
| | Variation (%) | | 0.43 | 0.85 | 0.86 | 1.08 | 7.55 | 9.58 | 12.38 | 16.30 |
| LEQ jitter (%) | Radial position | Inner | 5.7 | 5.7 | 6.0 | 5.8 | 5.8 | 6.0 | 5.9 | 6.0 |
| | | Intermediate | 5.7 | 5.8 | 5.8 | 6.0 | 5.9 | 6.0 | 6.0 | 5.9 |
| | | Outer | 6.0 | 5.9 | 5.8 | 5.7 | 6.8 | 7.3 | 7.6 | 7.9 |

As shown in Table 3, compared to the comparative example, both the reflection rate and C/N value had small variations between the inner, the intermediate and the outer radial positions. As for the LEQ jitter values, since these values themselves were small, the variations tended to increase. Thus, the LEQ jitter values need to satisfy 6.5 % or less of the standardized value over the inner, intermediate and outer radial position. In the comparative example, as the film forming rate increases, the reflection rate, C/N value and the value of LEQ jitter also have larger variations. Particularly, the properties are inferior at the outer radial position. It is assumed that for a high-speed film forming using the reactive film forming method, the recording layer is not uniformly formed over the inner to the outer radial positions.

Thus, when producing the recording layer of Te-O-Pd using the sputtering target of (TeO₂)₈₇Te₅Pd₈(mol%) including TeO₂ Te and Pd, and using the non-reactive film forming method, the variation of the reflectance ratio, C/N value and the jitter value over the entire disk were found to improve greatly and to be available for stable mass production compared to the conventional reactive film forming method, particularly in high film forming rate conditions.

From these findings, for producing the recording layer not by the reactive film forming method, but by mixing an oxide in a sputtering target and by mixing a slight amount of oxygen into a film forming gas, then a medium having few variations in properties and having a favorable signal recording property which is similar to that of a recording layer formed by a reactive film formation can be mass produced.

Note that, the effect of improving the stability of the film formation was also achieved by using the following components for the targets 34 and 35 of the example of the present invention: (TeO₂)₆₀Te₁₅Pd₂₅ (mol%), (TeO₂)₇₀Te₁₄Pd₁₆ (mol%), (TeO₂)₇₈Te₁₁Pd₁₁ (mol%), (TeO₂)₉₀Te₂Pd₈ (mol%), (TeO₂)₉₅Pd₅ (mol%), (TeO₂)₈₀Te₅Pd₁₀(SiO₂)₅ (mol%) or (TeO₂)₇₅Te₅Pd₁₀(SiO₂)₁₀ (mol%).

In addition, other than (TeO₂)-Te-Pd, the effect of improving the stability of the film formation was also achieved by using the following components: (TeO₂)₅₀Te₂₀Pd₈Sb₁₂(LaF₃)₁₀ (mol%), (TeO₂)₈₀te₅Au₁₀(LaF₃)₅ (mol%), (TeO₂)₇₅Te₅AU₁₀(LaF₃)₁₀ (mol%) or (TeO₂)₆₅Te₅Au₁₀(LaF₃)₂₀ (mol%).

Furthermore, in the quadruple-layer medium including four information layers shown in Fig. 4, a sputtering target of (TeO₂)₈₇ Te₅Pd₈ (mol%) containing TeO₂, Te and Pd was used and the non-reactive film forming method was applied. In this situation, the following layers were formed such as: the recording layer 102 of Te-O-Pd having 8 nm thickness; the recording layer 202 of Te-O-Pd having 10 nm thickness; the recording layer 302 of Te-O-Pd having 8 nm thickness; and the recording layer 402 of Te-O-Pd having 20 nm thickness. Compared to the results of the conventional reactive film forming method, performance variations over the entire medium were found to be remarkably improved. Particularly, the property variations of the following information layers having thin recording layers were remarkably reduced and a favorable quad-layer medium was obtained: the first information layer 100, the second information layer 200 and the third information layer 300.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing description of the embodiments according to the present invention is provided for illustration only, and not for the purpose of limiting the invention as defined by the appended claims and their equivalents.

## Claims

1. A method of manufacturing an information recording medium having at least a recording layer on a substrate and being able to record and reproduce information; wherein the recording layer contains an oxide of at least any one of Sb, Ge, Sn, In, Zn, Mo and W or an oxide A-O-M. A is a material which contains at least any one of Te, Sb, Ge, Sn, In, Zn, Mo and W, and M is a material which contains at least any one of a metal element, a semi-metal element, or a semiconductor-metal element; comprising employing a sputtering target used in a process of producing the recording layer which contains at least A-O, and A and /or M.

2. The method of manufacturing an information recording medium of claim 1, wherein the recording layer contains Te-O-M; and the sputtering target contains at least TeO₂ and M.

3. The method of manufacturing an information recording medium of claim 1 or 2, wherein the material M contains at least any one of Pd, Au, Pt, Ag, Cu, Sb, Bi, Ge, Si, Sn and In.

4. The method of manufacturing an information recording medium of claim 3, wherein the material M contains at least any one of Pd, Au, Pt and Ag.

5. The method of manufacturing an information recording medium of any of claims 2 to 4, wherein the sputtering target may contain a material X and is expressed as (TeO₂)ₐ Te_{b}M_{c}X_{d} (mol%), where a+b+c+d=100, 50 ≤a ≤95, 5 ≤ b+c ≤ 40, 0 ≤d ≤20, 0 ≤b, and 0 < c.

6. The method of manufacturing an information recording medium of claim 5, wherein 60 ≤a ≤90.

7. The method of manufacturing an information recording medium of claim 5, wherein 0.5b ≤c and 0 < b.

8. The method of manufacturing an information recording medium of claim 5 or 6, wherein the material X contains fluorides and/or oxides.

9. The method of manufacturing an information recording medium of any of claims 1 to 8, wherein a film forming gas used in the process of producing the recording layer contains at least a noble gas and O₂ gas, and when a flow rate of the noble gas is x and flow rate of the O₂ gas is y, then 0 ≤y ≤0.2x.

10. The method of manufacturing an information recording medium of claim 1, wherein the A-O of the recording layer is an oxide (the atomic ratio of O is less than the stoichiometric composition) and wherein the sputtering target contains at least an oxide A-O and A, and the oxide A-O has an atomic ratio of O to A which is within the stoichiometric composition range.

11. An information recording medium comprising a recording layer on a substrate, wherein the recording layer is produced by the manufacturing method of at least any of claims 1 to 10.

12. An information recording medium comprising multiple information layers, wherein at least one of the information layers has a recording layer that is produced by the manufacturing method of at least any of claims 1 to 10.

13. The method of manufacturing an information recording medium of any of claims 1 to 10, wherein two or more processes of producing the recording layer are employed, and wherein sputtering targets used in the processes have different compositions in at least two of the processes.

14. The manufacturing method of an information recording medium of any of claims 1 to 10, wherein composition ratios of oxygen which is contained in the sputtering targets are different in at least two of the processes of producing the recording layer,

15. The manufacturing method of an information recording medium of any of claims 1 to 10, wherein a film forming rate is 4.0 nm per second or more in the process of producing the recording layer.

16. A sputtering target for forming a recording layer comprising at least an oxide A-O, A and M, wherein A is a material which contains at least any one of Te, Sb, Ge, Sn, In, Zn, Mo, and W, and M is a material which contains at least any one of a metal element, a semi-metal element, and a semiconductor-metal element.

17. The sputtering target of claim 16, comprising at least TeO₂ and M.

18. The sputtering target of claim 16 or 17, wherein the material M comprises at least any one of Pd, Au, Pt, Ag, Cu, Sb, Bi, Ge, Si, Sn and In.

19. The sputtering target of claim 17 or 18, further comprising a material X which is expressed as (TeO₂)ₐTe_{b}M_{c}X_{d} (mol%), where a+b+c+d=100, 50 ≤a ≤95, 5 ≤ b+c ≤40, 0 ≤d ≤20, 0 ≤b, and 0 < c.

20. The sputtering target of claim 19, wherein 0.5b ≤c and 0 < b.

21. The sputtering target of claim 19 or 20, wherein the material X contains fluorides and/or oxides.

## Patentansprüche

1. Verfahren zur Herstellung eines Informationsaufnahmemediums mit zumindest einer Aufnahmeschicht auf einem Substrat und geeignet, Informationen aufzunehmen und zu reproduzieren, wobei die Aufnahmeschicht mindestens ein Oxid von Sb, Ge, Sn, In, Zn, Mo und W oder ein Oxid A-O-M enthält, A ein Material ist, das zumindest eines aus Te, Sb, Ge, Sn, In, Zn, Mo und W enthält und M ein Material ist, das zumindest eines aus einem Metallelement, einem Semi-Metallelement oder einem Halbleiter-Metallelement enthält, umfassend das Einsetzen eines Sputter-Targets, das in einem Verfahren zur Herstellung der Aufnahmeschicht, welche zumindest A-O und A und/oder M enthält, verwendet wird.

2. Verfahren zur Herstellung eines Informationsaufnahmemediums gemäß Anspruch 1, wobei die Aufnahmeschicht Te-O-M enthält und das Sputter-Target zumindest TeO₂ und M enthält.

3. Verfahren zur Herstellung eines Informationsaufnahmemediums gemäß Anspruch 1 oder 2, wobei das Material M zumindest eines aus Pd, Au, Pt, Ag, Cu, Sb, Bi, Ge, Si, Sn und In enthält.

4. Verfahren zur Herstellung eines Informationsaufnahmemediums gemäß Anspruch 3, wobei das Material M zumindest eines aus Pd, Au, Pt und Ag enthält.

5. Verfahren zur Herstellung eines Informationsaufnahmemediums gemäß einem der Ansprüche 2 bis 4, wobei das Sputter-Target ein Material X enthalten kann und als (TeO₂)ₐTe_{b}M_{c}X_{d} (Mol%) dargestellt wird, mit a+b+c+d=100, 50 ≤a ≤95, 5 ≤b+c ≤40, 0 ≤d ≤20,0 ≤b und 0 < c.

6. Verfahren zur Herstellung eines Informationsaufnahmemediums gemäß Anspruch 5 mit 60 ≤a ≤90.

7. Verfahren zur Herstellung eines Informationsaufnahmemediums gemäß Anspruch 5 mit 0,5 b ≤c und 0 < b.

8. Verfahren zur Herstellung eines Informationsaufnahmemediums gemäß Anspruch 5 oder 6, wobei das Material X Fluoride und/oder Oxide enthält.

9. Verfahren zur Herstellung eines Informationsaufnahmemediums gemäß einem der Ansprüche 1 bis 8, wobei ein filmbildendes Gas, das in dem Verfahren zur Herstellung der Aufnahmeschicht verwendet wird, zumindest ein Edelgas und O₂-Gas enthält, und wenn eine Flussrate des Edelgases x ist und eine Flussrate des O₂-Gases y ist, dann ist 0 ≤y ≤0,2x.

10. Verfahren zur Herstellung eines Informationsaufnahmemediums gemäß Anspruch 1, wobei das A-O der Aufnahmeschicht ein Oxid ist (das Atomverhältnis von O ist geringer als das der stöchiometrischen Zusammensetzung) und wobei das Sputter-Target zumindest ein Oxid A-O und A enthält und das Oxid A-O ein Atomverhältnis von O zu A hat, welches innerhalb des stöchiometrischen Bereiches der Zusammensetzung ist.

11. Informationsaufnahmemedium, umfassend eine Aufnahmeschicht auf einem Substrat, wobei die Aufnahmeschicht durch das Herstellungsverfahren gemäß mindestens eines der Ansprüche 1 bis 10 hergestellt wird.

12. Informationsaufnahmemedium, umfassend mehrere Informationsschichten, wobei zumindest eine der Informationsschichten eine Aufnahmeschicht hat, die durch das Herstellungsverfahren zumindest eines der Ansprüche 1 bis 10 hergestellt wird.

13. Verfahren zur Herstellung eines Informationsaufnahmemediums gemäß eines der Ansprüche 1 bis 10, wobei zwei oder mehrere Verfahren zur Herstellung der Aufnahmeschicht eingesetzt werden und wobei Sputter-Targets, die in den Verfahren verwendet werden, unterschiedliche Zusammensetzungen in zumindest zwei der Verfahren haben.

14. Verfahren zur Herstellung eines Informationsaufnahmemediums gemäß eines der Ansprüche 1 bis 10, wobei das Zusammensetzungsverhältnis von Sauerstoff, welches in den Sputter-Targets enthalten ist, in zumindest zwei der Verfahren zur Herstellung der Aufnahmeschicht unterschiedlich ist.

15. Verfahren zur Herstellung eines Informationsaufnahmemediums gemäß eines der Ansprüche 1 bis 10, wobei eine Filmbildungsrate 4,0 nm pro Sekunde oder mehr in dem Verfahren zur Herstellung der Aufnahmeschicht ist.

16. Sputter-Target zur Bildung einer Aufnahmeschicht, umfassend zumindest ein Oxid A-O, A und M, wobei A ein Material ist, das zumindest eines aus Te, Sb, Ge, Sn, In, Zn, Mo und W enthält und M ein Material ist, welches zumindest eines aus einem Metallelement, einem Halbmetallelement und einem Halbleiter-Metallelement enthält.

17. Sputter-Target gemäß Anspruch 16, umfassend zumindest TeO₂ und M.

18. Sputter-Target gemäß Anspruch 16 oder 17, wobei das Material M zumindest eines aus Pd, Au, Pt, Ag, Cu, Sb, Bi, Ge, Si, Sn und In umfasst.

19. Sputter-Target gemäß Anspruch 17 oder 18, weiter umfassend ein Material X, welches als (TeO₂)ₐTe_{b}M_{c}X_{d} (Mol%) dargestellt wird, mit a+b+c+d=100, 50 ≤ a ≤95, 5 ≤ b+c ≤40, 0 ≤d ≤20, 0 ≤b und 0 < c.

20. Sputter-Target gemäß Anspruch 19, mit 0,5b≤c und 0 < b.

21. Sputter-Target gemäß Anspruch 19 oder 20, wobei das Material X Fluoride und/oder Oxide enthält.

## Revendications

1. Procédé de fabrication d'un support d'enregistrement d'informations ayant au moins une couche d'enregistrement sur un substrat et étant capable d'enregistrer et de reproduire des informations ; dans lequel la couche d'enregistrement contient un oxyde d'au moins n'importe quel élément parmi du Sb, du Ge, du Sn, de l'In, du Zn, du Mo et du W ou un oxyde de matériau A-O-M, A est un matériau qui contient au moins n'importe quel élément parmi du Te, du Sb, du Ge, du Sn, de l'In, du Zn, du Mo et du W, et M est un matériau qui contient au moins n'importe quel élément parmi un élément métallique, un élément semi-métallique ou un élément métallique à semi-conducteur; comprenant l'utilisation d'une cible de pulvérisation utilisée dans un procédé de production de la couche d'enregistrement qui contient au moins un matériau A-O et au moins un matériau A et/ou M.

2. Procédé de fabrication d'un support d'enregistrement d'informations selon la revendication 1, dans lequel la couche d'enregistrement contient un matériau Te-O-M ; et la cible de pulvérisation contient au moins du TeO₂ et un matériau M.

3. Procédé de fabrication d'un support d'enregistrement d'informations selon la revendication 1 ou 2, dans lequel le matériau M contient au moins n'importe quel élément parmi du Pd, de l'Au, du Pt, de l'Ag, du Cu, du Sb, du Bi, du Ge, du Si, du Sn et de l'In.

4. Procédé de fabrication d'un support d'enregistrement d'informations selon la revendication 3, dans lequel le matériau M contient au moins n'importe quel élément parmi du Pd, de l'Au, du Pt et de l'Ag.

5. Procédé de fabrication d'un support d'enregistrement d'informations selon l'une quelconque des revendications 2 à 4, dans lequel la cible de pulvérisation peut contenir un matériau X et est exprimée par (TeO₂)ₐTe_{b}M_{c}X_{d} (% mol.), où a + b + c + d = 100, 50 ≤ a ≤ 95,5 ≤ b+c ≤ 40,0 ≤d ≤ 20,0 ≤ b, et 0 < c.

6. Procédé de fabrication d'un support d'enregistrement d'informations selon la revendication 5, dans lequel 60 ≤ a ≤ 90.

7. Procédé de fabrication d'un support d'enregistrement d'informations selon la revendication 5, dans lequel 0,5b ≤ c et 0 < b.

8. Procédé de fabrication d'un support d'enregistrement d'informations selon la revendication 5 ou 6, dans lequel le matériau X contient des fluorures et/ou des oxydes.

9. Procédé de fabrication d'un support d'enregistrement d'informations selon l'une quelconque des revendications 1 à 8, dans lequel un gaz filmogène utilisé dans le procédé de production de la couche d'enregistrement contient au moins un gaz noble et un gaz O₂, et lorsqu'un débit du gaz noble est x et un débit du gaz O₂ est y, alors 0 5 y ≤ 0,2x.

10. Procédé de fabrication d'un support d'enregistrement d'informations selon la revendication 1, dans lequel le matériau A-O de la couche d'enregistrement est un oxyde (le rapport atomique de O est inférieur à la composition stoechiométrique) et dans lequel la cible de pulvérisation contient au moins un oxyde de matériau A-O et un matériau A, et l'oxyde de matériau A-O a un rapport atomique de O sur A qui se situe dans la plage de composition stoechiométrique.

11. Support d'enregistrement d'informations comprenant une couche d'enregistrement sur un substrat, dans lequel la couche d'enregistrement est produite grâce au procédé de fabrication selon au moins l'une quelconque des revendications 1 à 10.

12. Support d'enregistrement d'informations comprenant de multiples couches d'informations dans lequel au moins une des couches d'informations a une couche d'enregistrement qui est produite grâce au procédé de fabrication selon au moins l'une quelconque des revendications 1 à 10.

13. Procédé de fabrication d'un support d'enregistrement d'informations selon l'une quelconque des revendications 1 à 10, dans lequel deux procédés de production de la couche d'enregistrement ou plus sont utilisés, et dans lequel les cibles de pulvérisation utilisées dans les procédés ont des compositions différentes dans au moins deux des procédés.

14. Procédé de fabrication d'un support d'enregistrement d'informations selon l'une quelconque des revendications 1 à 10, dans lequel les rapports de composition de l'oxygène qui est contenu dans les cibles de pulvérisation sont différents dans au moins deux des procédés de production de la couche d'enregistrement.

15. Procédé de fabrication d'un support d'enregistrement d'informations selon l'une quelconque des revendications 1 à 10, dans lequel un rythme de formation de film est égal à 4,0 nm par seconde ou plus dans le procédé de production de la couche d'enregistrement.

16. Cible de pulvérisation destinée à former une couche d'enregistrement comprenant au moins un oxyde de matériau A-O, un matériau A et un matériau M, dans laquelle le matériau A est un matériau qui contient au moins n'importe quel élément parmi du Te, du Sb, du Ge, du Sn, de l'In, du Zn, du Mo et du W, et le matériau M est un matériau qui contient au moins n'importe quel élément parmi un élément métallique, un élément semi-métallique et un élément métallique à semi-conducteur.

17. Cible de pulvérisation selon la revendication 16, comprenant au moins du TeO₂ et un matériau M.

18. Cible de pulvérisation selon la revendication 16 ou 17, dans laquelle le matériau M comprend au moins n'importe quel élément parmi du Pd, de l'Au, du Pt, de l'Ag, du Cu, du Sb, du Bi, du Ge, du Si, du Sn et de l'In.

19. Cible de pulvérisation selon la revendication 17 ou 18, comprenant en outre un matériau X qui est exprimé par (TeO₂)ₐTe_{b}M_{c}X_{d} (%mol.), où a + b + c + d = 100,50 ≤ a ≤ 95,5 ≤ b+c ≤ 40,0 ≤ d ≤ 20,0 ≤ b, et 0 < c.

20. Cible de pulvérisation selon la revendication 19, dans laquelle 0,5b ≤ c et 0 < b.

21. Cible de pulvérisation selon la revendication 19 ou 20, dans laquelle le matériau X contient des fluorures et/ou des oxydes.
